# EUROPEAN PATENT SPECIFICATION

(11) **EP 0 883 100 B1**
(45) Date of publication and mention of the grant of the patent: **04.05.2005**
(21) Application number: 98108796.8
(22) Date of filing: 14.05.1998
(51) Int. Cl.: G09F 9/33, H05K 5/00, G08G 1/09

(54) **Casing for variable message displaying devices**
Gehäuse für Anzeigevorrichtung mit wechselnder Anzeige
Boîtier pour dispositifs d'affichage de messages variables

(30) Priority: 15.05.1997 IT MI970341 U
(43) Date of publication of application: 09.12.1998
(73) Proprietor: S.I.M. S.p.a., 25124 Brescia (IT)
(72) Inventor: Alberti, Cesare, 25081 Bedizzole (Brescia) (IT)
(74) Representative: Cicogna, Franco

(56) References cited:
- US-A- 4 271 408
- US-A- 4 553 345
- PATENT ABSTRACTS OF JAPAN vol. 1997, no. 08, 29 August 1997 (1997-08-29) & JP 09 097020 A (IWASAKI ELECTRIC CO LTD), 8 April 1997 (1997-04-08)
- PATENT ABSTRACTS OF JAPAN vol. 018, no. 564 (P-1819), 27 October 1994 (1994-10-27) & JP 06 203295 A (IWASAKI ELECTRIC CO LTD), 22 July 1994 (1994-07-22)

## Description

### BACKGROUND OF THE INVENTION

The present invention relates to a casing for variable message displaying devices.

In particular, the present invention relates to a casing, including a box-like body, housing therein the electronic components and light emitting elements, which are electrically controlled to display messages, information and the like, by causing said light emitting elements to be controllably switched on and off, in particular for use in traffic signs and the like.

A main problem affecting prior displaying devices is that, under a condition in which the sun rays impinges with an angle on the display surface, light reflections do not allow a person to properly read-out the displayed information.

This read-out difficulties are very objectabl as the person the displayed messages are directed to drives a motor vehicle since in this case said person for time reasons or the like, can not accurately read the displayed message.

In this connection it should be apparent that this drawback could cause a great danger for a driver if the displayed information would relate to traffic and/or climatic conditions.

It is known from JP-A-07274965 to insert hooded LED elements into a matrix of slots in a frame.

A further problem affecting prior displaying device casings is that of properly protecting the electric and electronic components housed therein from atmospheric agents, possible impacts and/or vandalic acts, which would hinder a proper operation of the displaying means.

### SUMMARY OF THE INVENTION

Accordingly, the aim of the present invention is to provide a casing or case for displaying devices which is very reliable and safe in operation.

Within the scope of the above mentioned aim, a main object of the present invention is to provide such a casing allowing displayed messages to be easily read-out, under any impinging light conditions.

Another object of the present invention is to provide such a casing which is very strong and properly environmentally sealed.

According to one aspect of the present invention, the above mentioned aim and objects, as well as yet other objects, which will become more apparent hereinafter, are achieved by a casing for variable message displaying devices, of the type comprising a box-like body for housing therein electronic circuit panels as well as light emitting elements, closed at the front thereof by a perforated element and a flat element, said perforated and flat elements adjoining one another, in which each of said light emitting elements is arranged at a hole of said perforated element, characterized in that said casing comprises moreover a panel, arranged on the front of said flat element and provided with a plurality of horizontally projecting fins and a plurality of openings, each of said openings being arranged at a hole of said perforated element in order to allow the light of a said light emittihng element to pass through said hole.

Preferably, the casing according to the present invention comprises a plurality of metal section members coupled, at at a least one of the sides thereof, to a side of the perforated element in order to provide a tight sealing.

Moreover, each horizontal row of the openings of the panel is contoured at the top thereof by one of said horizontally extending fins.

According to a preferred embodiment of the invention, at least one of said perforated elements, flat element and finned element comprises a plurality of adjoining mating portions.

Finally, said flat element comprises at least a opaque or glazed plastic material layer.

The present invention provides the following advantages over the prior art.

At first, since each horizontal row of openings therethrough the light emitted by said light emitting elements is caused to pass is contoured at the top thereof by one of the horizontal fins pertaining to the finned panel, it will allow to protect against the impinging light said openings thereby preventing undesired reflection effects susceptible to hinder a proper reading-out of displayed messages.

The anti-reflection capabilities of the present invention are moreover enhanced by using an opaque material for forming said flat element.

Moreover, the casing is provided with a strong and tightly sealed construction, and moreover it can be easily assembled.

Finally, said casing or case may be assembled by using a plurality of mating components to easily form both the flat element and perforated element, as well as the finned panel, which will allow to easily construct casings or cases of different size, depending on requirements.

### BRIEF DESCRIPTION OF THE DRAWINGS

The present invention will be disclosed hereinafter, by way of an illustrative but not limitative example, with reference to the accompanying drawings, where:
Figure 1 is an axonometric exploded view illustrating the casing or case for variable message displaying devices according to the present invention;
Figure 2 is an axonometric view of the rear portion of the display device casing or case shown in Figure 1;
Figure 3 is a partially cross-sectioned side view illustrating the casing according to the invention;
Figure 4 is an axonometric view of the variable message display device casing according to the invention;
   and
Figure 5 is a front view of a detail of an anti-reflection panel applied to the casing of the preceding figures.

### DESCRIPTION OF THE PREFERRED EMBODIMENTS

The variable message display device casing according to the present invention will be disclosed hereinafter, by way of an illustrative example, with reference to a preferred embodiment of the invention.

More specifically, in the disclosed casing, both the flat element and the perforated element, as well as the finned panel, are each formed by four mating portions, but they can also comprise a different number of portions, depending on the requirements, without departing from the scope of the invention.

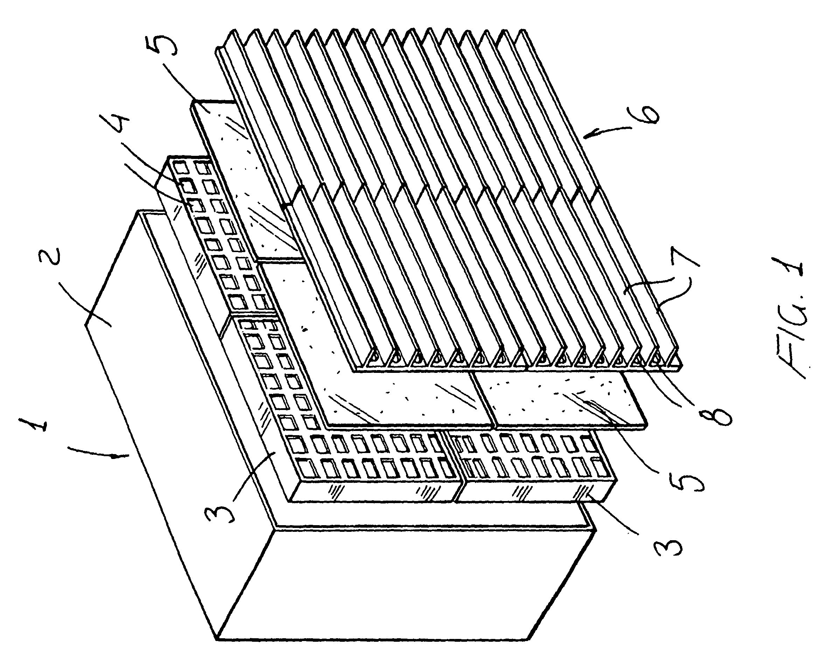

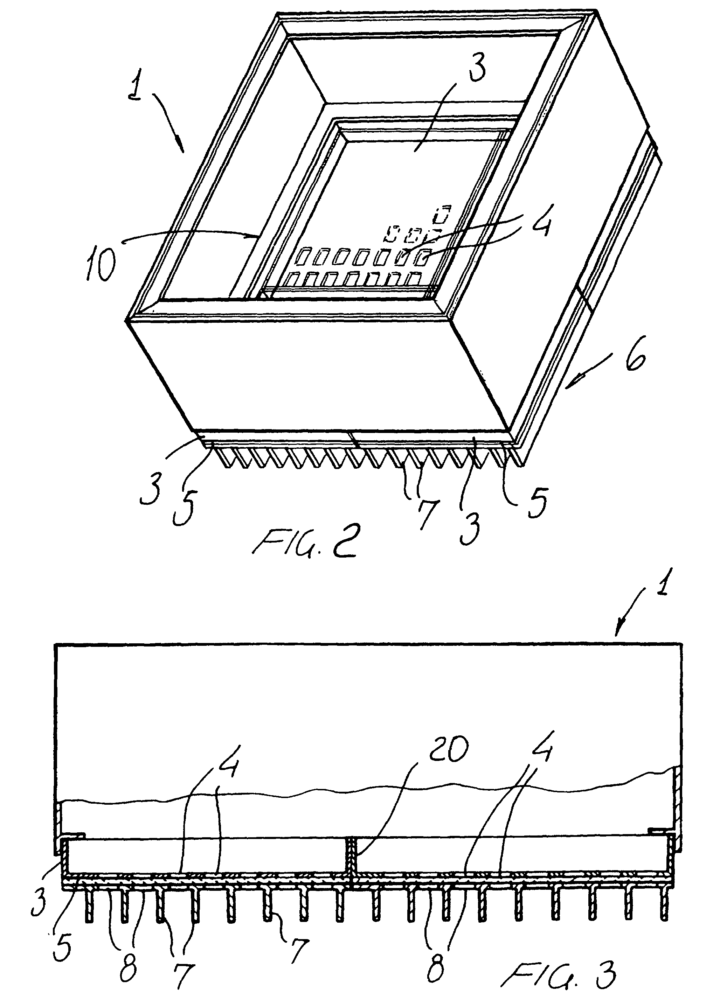

Figure 1 is an exploded perspective view illustrating a casing 1 for holding herein variable message displaying devices.

Said casing comprises a box-like body 2, formed by metal section members defining a cavity inside of which will be housed and protected the components of the variable message displaying device.

The display device, in particular, comprises, according to the prior art, a plurality of light emitting elements (for example lamps or LED's) which can be switched on and off individually and/or in groups, according to preset switching sequences, by electronic control means, in order to provide variable messages.

For simplicity, the display device including said components has not been shown in the accompanying drawings.

At the front of said box-like body 1, a perforated element 3, preferably made of a metal material and including a plurality of holes 4 is provided.

At each of said holes 4 is arranged one of the mentioned light emitting elements.

On the front of said perforated element 3 a flat or planar element 5 is arranged.

Said flat element 5 comprises at least an opaque or translucid plastic material layer, or an opaque glass layer, so selected as to provide anti-reflection capabilities, while allowing the light of said light elements to pass therethrough.

Said flat or planar element 5, moreover, separates the perforated element 3 from a panel 6, generally made of a metal material, including a plurality of fins 7, extending outwardly according to a substantially horizontal arrangement.

The panel 6 is moreover provided with a plurality of openings 8, each of said openings being arranged at one of said holes 4 of said perforated element 3, and separated therefrom by a portion of the flat or planar element 5.

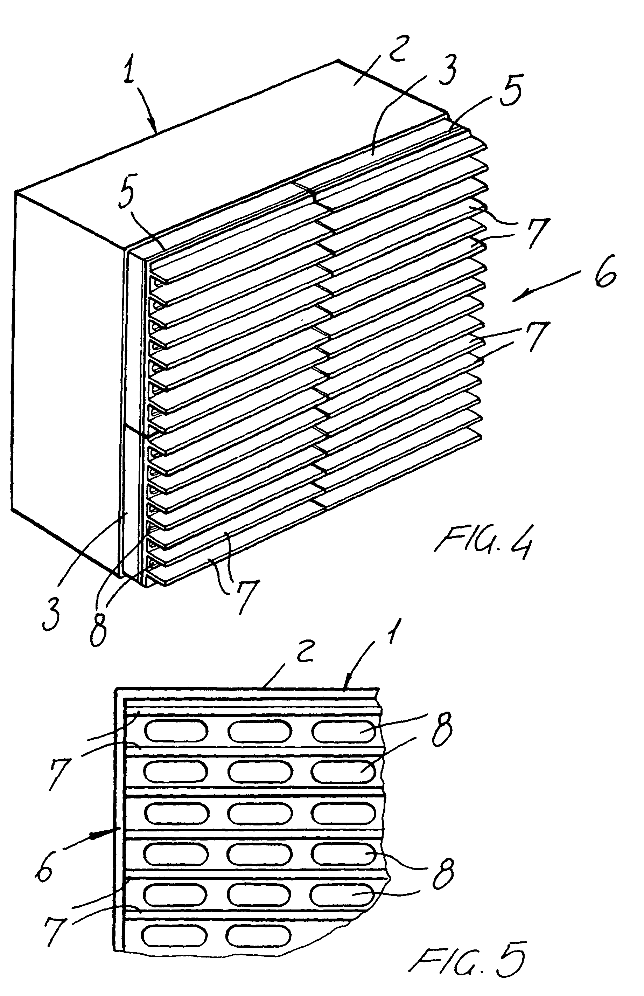

Figure 2 is a perspective view illustrating the rear portion of the display device casing 1.

This figure clearly shows that the box-like body 1 comprises a cavity or hollow 10 for housing therein the electronic components as well as the light elements of the display device.

Said figure shows moreover the perforated element 3, provided with the throughgoing holes 4, as well as the edge or rim of the flat element 5 and said panel 6.

Figure 3 is a partially cross-sectioned side view illustrating the casing according to the invention.

From this figure it should be apparent that the flat element 5 is arranged between the perforated element 3 and panel 7, in an adjoining relationship therewith, thereby facilitating a tight closure of the cavity 10.

Figure 3 also illustrates the perforated element 3 comprising components adjoining along a line 20.

Like separating lines will separate the adjoining components forming the flat element 5 and finned panel 6.

Figure 4 is a perspective view of the variable message display device casing, in its assembled condition.

In particular, Figure 4 clearly shows the substantially horizontal arrangement of the fins 7.

Figure 5 is a front view illustrating a detail of a panel 6, the openings 8 and fins 7 of said panel being clearly herein shown.

In the above disclosed casing 1, a mating relationship is formed between each light element, the hole 4 associated therewith and the openings 8 each of which is arranged on the front of a hole 4.

Thus, the light emitted by the light emitting elements can be seen outside of the casing.

By causing the light elements to switch on and off with an electronically controlled timing, it will be possible to display variable messages.

The horizontal fins 7 will protect the openings 8 from the impinging sun light, thereby overcoming possible reflections susceptible to hinder a proper read-out of the light messages.

Moreover, the flat element 5, with its anti-reflection capabilities, will improve the message visibility.

The provision on the perforated element 3 of sides extended to the inside of the casing 1 will provide a proper coupling with the metal section members 2.

This feature will provide the casing with very good strength properties, and which allow said casing 1 to be properly tightly closed thereby protecting the components housed therein.

## Claims

1. A casing for variable message displaying devices, of the type comprising a box-like body (1) for housing therein electronic circuit panels as well as light emitting elements, closed at the front thereof by a perforated element (3) and a flat element (5), said perforated and flat elements adjoining one another, in which each of said light emitting elements is arranged at a hole (4) of said perforated element, **characterized in that** said casing (1) comprises moreover a panel (6), arranged on the front of said flat element (5) and provided with a plurality of horizontally projecting fins (7) and a plurality of openings (8), each of said openings being arranged at a hole (4) of said perforated element (3) in order to allow the light of a said light emitting element to pass through said hole.

2. A casing according to Claim 1, **characterized in that** said box-like body (1) comprises a plurality of metal section members (2) connected on at least one of the sides thereof to one side of said perforated element (3) in order to provide a tight sealing.

3. A casing according to one or more of the preceding claims, **characterized in that** each horizontal row of the opening (8) of said panel is contoured at the top thereof by one of said horizontal fins (7).

4. A casing according to one or more of the preceding claims, **characterized in that** at least a perforated element (3), flat element (5) and finned panel (6) comprises a plurality of adjoining mating portions.

5. A casing according to one or more of the preceding claims, **characterized in that** said flat element (5) comprises at least an opaque or glazed plastic material layer.

## Patentansprüche

1. Gehäuse für Anzeigevorrichtung mit wechselnder Anzeige, von der Art, das einen kastenförmigen Körper (1) zur dortigen Unterbringung von elektronischen Schalttafeln und lichtemittierenden Elementen umfasst, das an seiner Vorderseite durch ein gelochtes Element (3) und ein flaches Element (5) geschlossen ist, wobei die gelochten und flachen Elemente aneinander angrenzen, in dem jedes von den lichtemittierenden Elementen an einem Loch (4) vom gelochten Element angeordnet ist, **dadurch gekennzeichnet, dass** das Gehäuse (1) ferner eine Tafel (6) umfasst, die an der Vorderseite vom flachen Element (5) angeordnet ist und die mit mehreren horizontal vorstehenden Lamellen (7) und mehreren Öffnungen (8) bereit gestellt ist, wobei jede der Öffnungen an einem Loch (4) vom gelochten Element (3) angeordnet ist, damit das Licht von einem lichtemittierenden Element durch das Loch strahlen kann.

2. Gehäuse nach Anspruch 1, **dadurch gekennzeichnet, dass** der kastenförmige Körper (1) mehrere Profilteile aus Metall (2) umfasst, die zumindest an einer ihrer Seiten mit einer Seite vom gelochten Element (3) verbunden sind, um eine feste Abdichtung zu verschaffen.

3. Gehäuse nach einem oder mehreren der vorhergehenden Ansprüche, **dadurch gekennzeichnet, dass** jede horizontale Reihe der Öffnung (8) von der Tafel an ihrem Oberrand von einer der horizontalen Lamellen (7) eingefasst ist.

4. Gehäuse nach einem oder mehreren der vorhergehenden Ansprüche, **dadurch gekennzeichnet, dass** zumindest ein gelochtes Element (3), ein flaches Element (5) und eine Lamellentafel (6) mehrere angrenzende Passteile umfasst.

5. Gehäuse nach einem oder mehreren der vorhergehenden Ansprüche, **dadurch gekennzeichnet, dass** das flache Element (5) zumindest eine opake oder glasierte Kunststoffschicht umfasst.

## Revendications

1. Boîtier pour des dispositifs d'affichage de messages variables, comprenant un corps en forme de caisson (1) afin de loger des panneaux de circuits électroniques ainsi que des éléments émetteurs de lumière, fermé à l'avant par un élément perforé (3) et un élément plat (5), ledit élément perforé et ledit élément plat étant adjacents, dans lequel chacun desdits éléments émetteurs de lumière est disposé au niveau d'un trou (4) dans ledit élément perforé, **caractérisé en ce que** ledit boîtier comprend en outre un panneau (6) disposé à l'avant dudit élément plat (5) et muni d'une pluralité d'ailettes horizontales (7) et d'une pluralité d'ouvertures (8), chacun desdites ouvertures étant disposées au niveau d'un trou (4) dudit élément perforé (3) afin de permettre à la lumière dudit élément émetteur de lumière de traverser ledit trou.

2. Boîtier selon la revendication 1, **caractérisé en ce que** ledit corps en forme de caisson (1) comprend une pluralité d'éléments de séparation métalliques (2) reliés, sur au moins un des côtés, à un côté dudit élément perforé (3) afin d'obtenir une étanchéité.

3. Boîtier selon l'une ou plusieurs des revendications précédentes, **caractérisé en ce que** chaque rangée horizontale d'ouvertures (8) dudit panneau est limitée en hauteur par une desdites ailettes horizontales (7).

4. Boîtier selon l'une ou plusieurs des revendications précédentes, **caractérisé en ce qu'**au moins un élément perforé (3), un élément plat (5) et un panneau muni d'ailettes (6) comprend une pluralité de parties adjacentes reliées entre elles.

5. Boîtier selon l'une ou plusieurs des revendications précédentes, **caractérisé en ce que** ledit élément plat (5) comprend au moins une couche de matière plastique opaque ou vitrée.
